# EUROPÄISCHE PATENTSCHRIFT

(11) **EP 3 528 345 B1**
(45) Veröffentlichungstag und Bekanntmachung des Hinweises auf die Patenterteilung: **23.08.2023**
(21) Anmeldenummer: 19153414.8
(22) Anmeldetag: 23.05.2018
(51) Int. Cl.: H01R 13/422, H01B 1/20, H01R 25/14

(54) **VERBINDUNGSVORRICHTUNG ZUR ÜBERTRAGUNG ELEKTRISCHER ENERGIE**
CONNECTION DEVICE FOR THE TRANSMISSION OF ELECTRIC POWER
DISPOSITIF DE RACCORDEMENT PERMETTANT DE TRANSMETTRE DE L'ÉNERGIE ÉLECTRIQUE

(30) Priorität: 19.02.2018 DE 102018103667
(43) Veröffentlichungstag der Anmeldung: 21.08.2019
(62) Teilanmeldung aus: 18173818.8
(73) Patentinhaber: TGW Mechanics GmbH, 4600 Wels (AT)
(72) Erfinder: Pfeiffer-Wagner, Klaus, 92637 Weiden (DE)
(74) Vertreter: Peters, Andreas

(56) Entgegenhaltungen:
- WO-A1-2014/143020
- US-A1- 2017 194 757

## Beschreibung

Die vorliegende Erfindung betrifft eine Verbindungsvorrichtung zur Übertragung elektrischer Energie von einer, vorzugsweise räumlich fixierten, Leitungsschiene auf eine entlang der Leitungsschiene bewegbare oder ebenso räumlich fixierte Abgreifvorrichtung, gemäß dem Oberbegriff des Patentanspruchs 1.

Bei der Leitungsschiene kann es sich insbesondere um eine Anordnung von einer Mehrzahl von parallel zueinander verlegten länglichen elektrischen Leitern handeln, welche beispielsweise einzeln oder gemeinsam, in weiteren Isolationselementen, z.B. Plastikkörpern, gelagert sind. Zudem kann die Leitungsschiene in einem Fabrikationsraum, beispielsweise auf dessen Fußboden, fest montiert sein, ohne dass sich während des Betriebs die Leitungsschiene relativ zum Fußboden bewegt.
Beispielsweise können die einzelnen elektrischen Leiter schienenförmig, vorzugsweise auch entlang einer Schiene oder in Form einer Schienenführung, geführt werden.

Um nun beispielsweise einen Fertigungsroboter beständig, d.h. dauerhaft mit elektrischer Energie zu versorgen, ist es daher oftmals nötig, zwischen der oben genannten Leitungsschiene und einem solchen elektrisch zu betreibenden Fertigungsroboter oder einem sonstigen elektrisch betreibbaren Element eine Abgreifvorrichtung zu installieren.

Beispielsweise ist die Abgreifvorrichtung entlang der Haupterstreckungsrichtung der Leitungsschiene, vorzugsweise zusammen mit einem solchen Roboter bewegbar, während der Bewegung jedoch im ständigen elektrischen Kontakt mit der Leitungsschiene.
Alternativ hierzu können auch beide Komponenten räumlich fixiert sein.

Mit anderen Worten ermöglicht daher die Abgreifvorrichtung eine zuverlässige Stromversorgung des Roboters oder des sonstigen elektrischen Elementes mit elektrischer Energie, unabhängig davon, an welcher Stelle sich der Roboter relativ zu der Leitungsschiene befindet, solange die Abgreifvorrichtung in zuverlässigem, elektrischem Kontakt mit der Leitungsschiene steht.

Dabei bedarf es jedoch einer Vorrichtung, welche die Leitungsschiene und die Abgreifvorrichtung elektrisch leitend miteinander kontaktiert. Hierzu dient die Verbindungsvorrichtung.

Die US 2017/0194757 A1 offenbart eine Kontaktvorrichtung zur Übertragung von elektrischer Energie von einer vorzugsweise ortsfesten Stromschiene auf eine entlang der Stromschiene bewegliche Abgriffsschiene, umfassend: mindestens ein Anschlußgehäuse, wobei die Stromsammelschiene durch das Anschlußgehäuse mechanisch mit der Abgriffsschiene verbunden ist, mindestens einen Kombiclip, wobei der Kombiclip mit einem Teil des Außenumfangs des Anschlußgehäuses mechanisch lösbar in Eingriff gebracht ist und eine mechanische Verbindung zwischen dem Anschlußgehäuse und einem Anschlußbügel herstellt, mindestens ein Leistungssteckergehäuse, wobei das Leistungssteckergehäuse mechanisch und von außen auf der Stromsammelschiene und/oder auf der Abgriffsschiene positioniert ist, so daß eine mechanische Verbindung zwischen dem Anschlußgehäuse und der Stromsammelschiene und/oder der Abgriffsschiene durch das Leistungssteckergehäuse hergestellt wird.

In der WO 2014/143020 A1 wird eine einziehbare Verbinderbaugruppe zum Herstellen einer elektrischen Verbindung mit einer Stromsammelschiene von einem elektrischen Gerät offenbart. Die einziehbare Verbinderanordnung umfasst eine Rahmenplatte und einen Schlitten. Der Schlitten hat eine Zahnstange und eine Verbinderanordnung mit einem elektrischen Kontakt. Der Schlitten hat eine ausgefahrene Position und eine eingefahrene Position relativ zur Rahmenplatte. An der Rahmenplatte ist ein Stirnradgetriebe montiert. Das Stirnrad greift in die Zahnstange ein, um den Schlitten zwischen der eingefahrenen Position und der ausgefahrenen Position zu bewegen, wenn das Stirnrad gedreht wird. Der elektrische Kontakt stellt eine elektrische Verbindung mit der Stromschiene her, wenn sich der Schlitten in der ausgefahrenen Position, aber nicht in der eingefahrenen Position befindet. Für die Steckerbaugruppe können Sicherheitsverriegelungen und Kennzeichnungen vorgesehen werden.

Die hier beschriebene Verbindungsvorrichtung dient zur Übertragung elektrischer Energie von einer, vorzugsweise räumlich fixierten Leitungsschiene, auf eine entlang der Leitungsschiene bewegbaren oder ebenso räumlich fixierten Abgreifvorrichtung. Diese umfasst zumindest ein Verbindungsgehäuse, wobei über das Verbindungsgehäuse die Leitungsschiene mechanisch mit der Abgreifvorrichtung verbunden ist. Das Verbindungsgehäuse umfasst dabei zumindest einen Basisträger, auf welchem Verbindungsbauelemente, zum Beispiel zumindest eine Anschlussklemme, montiert sind.

Bei der Abgreifvorrichtung (= Connectormodul) kann es sich um ein von der Verbindungsvorrichtung verschiedenes Bauteil handeln. Zum Beispiel wird oder ist die Abgreifvorrichtung lösbar mit der Verbindungsvorrichtung verbindbar. Die Abgreifvorrichtung kann ein Bestandteil eines Fertigungselements, zum Beispiel eines Roboters sein, oder aber die Abgreifvorrichtung ist in mechanischer und/oder elektrischer Hinsicht zwischen der Verbindungsvorrichtung und dem Fertigungselement geschaltet.

Der Basisträger kann in Form einer Basisplatte ausgebildet sein und aus einem elektrisch isolierenden Material gebildet sein, auf welchem elektrische Leitungen verlegt sind. Hierzu kommt ein Kunststoff oder Keramik in Frage.

Zudem umfasst die Verbindungsvorrichtung erfindungsgemäß eine Stromabgreifvorrichtung, welche wiederrum zumindest ein Schleifkontaktelement zur Abnahme elektrischer Energie von der Leitungsschiene umfasst. Die Schleifkontaktelemente sind durch den Basisträger hindurch geführt und weisen auf einer der Leitungsschiene abgewandten Seite des Basisträgers einen Kontaktierungsbereich auf, mittels dessen zumindest eine Leiterplatine der Verbindungsvorrichtung und/oder zumindest eine Leiterplatine der Abgreifvorrichtung elektrisch leitend kontaktierbar ist.

Zum Beispiel sind die Schleifkontaktelemente in Form von Schleifaufsteckelementen ausgebildet, sodass das Verbindungsgehäuse werkzeugfrei auf die Leitungsschiene aufsteckbar ist.

Ein Schleifaufsteckelement kann im Sinne der Erfindung ein Element sein, welches an eine Leitung der Leitungsschiene aus einer Richtung angeordnet werden kann und während des Anpositioniervorgangs eine Steckverbindung zwischen der Leitungsschiene oder sogar eine der Leitungen selbst und dem Verbindungsgehäuse entsteht. Dabei kann die Steckverbindung in Form einer Plug-and-Place Verbindung ausgebildet sein.
Auch kann die Steckverbindung in Form einer Clipsverbindung ausgebildet sein. Eine solche Clipsverbindung kann ein Schnappelement (den Clips) umfassen, welcher sich nach dem Einrasten umfänglich um eine Leitung der Leitungsschiene legt.

Gemäß zumindest einer Ausführungsform ist die mechanische Verbindung mit dem Verbindungsgehäuse, insbesondere nur, durch seitliches Aufschieben (= Aufklippen) der Schleifkontaktverbindung, insbesondere der Clipsverbindung, auf jede der Leitung hergestellt.

Die Verbindung zwischen dem Verbindungsgehäuse und der Leitungsschiene ist zum Beispiel frei von jeglichen weiteren Befestigungselementen, wie beispielsweise Schrauben, Haftbolzen oder Spannelementen.

Erfindungsgemäß ist die Verbindungsvorrichtung zur Übertragung elektrischer Energie von einer, vorzugsweise räumlich fixierten, Leitungsschiene auf eine entlang der Leitungsschiene bewegbare oder ebenso räumlich fixierte Abgreifvorrichtung verbunden. Die Verbindungsvorrichtung umfasst zumindest ein Verbindungsgehäuse, wobei über das Verbindungsgehäuse die Leitungsschiene mechanisch mit der Abgreifvorrichtung verbunden ist, wobei das Verbindungsgehäuse zumindest einen Basisträger umfasst, auf welchem Verbindungsbauelemente montiert sind, zum Beispiel zumindest eine Anschlussklemme. Außerdem umfasst die Verbindungsvorrichtung eine Stromabgreifvorrichtung, welche Schleifkontaktelemente zur Abnahme elektrischer Energie von der Leitungsschiene umfasst. Hier sind die Schleifkontaktelemente durch den Basisträger hindurch geführt und weisen auf einer der Leitungsschiene abgewandten Seite des Basisträgers einen Kontaktierungsbereich auf, mittels dessen Verbindungsbauelemente wie zumindest eine Leiterplatine der Verbindungsvorrichtung und/oder zumindest eine Leiterplatine der Abgreifvorrichtung elektrisch leitend kontaktierbar ist.

Zum Beispiel sind die Schleifkontaktelemente in Form von Schleifaufsteckelementen ausgebildet, sodass das Verbindungsgehäuse werkzeugfrei auf die Leitungsschiene aufsteckbar ist.

Gemäß zumindest einer Ausführungsform ist das Verbindungsgehäuse, zumindest teilweise oder ganz, wie nun nicht abschließend unten gezeigt, mittels folgender 3D-Printtechnologien gefertigt:

### 1. Das FDM-Verfahren (Fused Deposition Modeling)

### Alternativbezeichnungen: Fused Filament Fabrication (FFF), Fused Layer Modeling (FLM)

Das Verfahren bezeichnet schichtweises Auftragen (Extrusion) eines Materials durch eine heiße Düse. Das Verbrauchsmaterial befindet sich in Form eines langen Drahts (sog. Filament) auf einer Rolle und wird durch die Fördereinheit in einen Druckkopf geschoben, dort eingeschmolzen und auf einem Druckbett aufgebracht. Druckkopf und/oder Druckbett sind dabei in 3 Richtungen beweglich. So können Kunststoffschichten schrittweise aufeinander aufgebracht werden.

### 2. Das SLS-Verfahren (Selektives Lasersintern)

Im Unterschied zum Sinterverfahren, bei dem Stoffe in Pulverform unter Hitzeeinwirkung miteinander verbunden werden, geschieht dies beim SLS-Verfahren selektiv durch einen Laser (alternativ auch Elektronenstrahl oder Infrarotstrahl). Es wird also nur ein bestimmter Teil des Pulvers miteinander verschmolzen.

Dazu wird stets eine dünne Pulverschicht von der Beschichtungseinheit auf dem Druckbett aufgebracht. Der Laser (oder eine andere Energiequelle) wird nun punktgenau auf einzelne Stellen der Pulverschicht ausgerichtet, um die erste Schicht der Druckdaten auszubilden. Hierbei wird das Pulver an- oder aufgeschmolzen und verfestigt sich anschließend wieder durch geringfügiges Abkühlen. Das nicht aufgeschmolzene Pulver bleibt um die gesinterten Bereiche herum liegen und dient als Stützmaterial. Nachdem eine Schicht verfestigt ist, senkt sich das Druckbett um den Bruchteil eines Millimeters ab. Die Beschichtungseinheit fährt nun über das Druckbett und bringt die nächste Pulverschicht auf. Anschließend wird die zweite Schicht der Druckdaten durch den Laser (oder eine andere Energiequelle) gesintert. So entsteht schichtweise ein dreidimensionales Objekt.

### 3. Three-Dimensional Printing (3DP)

Das SDP-Verfahren funktioniert sehr ähnlich wie das selektive Lasersintern, doch anstelle einer gerichteten Energiequelle verfährt ein Druckkopf über das Pulver. Dieser gibt winzige Tröpfchen von Bindemittel auf die zugrunde liegenden Pulverschichten ab, die so miteinander verbunden werden. Ansonsten ist dieses Verfahren dem SLS-Verfahren gleich.

### 4. Stereolithographie (SLA)

Anstelle eines Kunststoffdrahts oder Druckmaterials in Pulverform kommen beim Stereolithographie-Verfahren flüssige Harze, sog. Photopolymere, zum Einsatz. Sie werden schichtweise durch UV-Strahlung verhärtet und erzeugen so dreidimensionale Objekte. Dafür wird die Bauplattform im Harzbecken schrittweise abgesenkt. Es gibt auch Varianten (sog. Polyjet-Verfahren) ohne ein ganzes Becken mit flüssigem Harz. Dafür wird ein Epoxydharz tröpfchenweise aus einer Düse aufgebracht und durch einen UV-Laser sofort ausgehärtet.

### 5. Laminated Object Manufacturing (LOM)

### Alternativbezeichnung: Layer Laminated Manufacturing (LLM)

Das Verfahren basiert weder auf chemischen Reaktionen, noch auf einem thermischen Prozess. Es wird dabei mit einem trennenden Werkzeug (z.B. einem Messer oder Kohlendioxidlaser) eine Folie oder Platte (z.B. Papier) an der Kontur geschnitten und schichtweise aufeinander geklebt. So entsteht durch Absenken der Bauplattform ein Schichtobjekt aus geklebten, übereinanderliegenden Folien.

Gemäß zumindest einer Ausführungsform ist das Verbindungsgehäuse mit einem Kunststoffmaterial gebildet, welches aus einer Gruppe ausgewählt ist, welche Polyethylen (PE), Polyether/Etherketonen (PEEK), Polyoxymethylen (POM), und insbesondere Ulta-High-Molecular-Weight-Polyethylen (UHMW-PE), PP (Polypropylen), PA (Polyamid) - insbesondere PA46, PA6, PA6.6, PA11 oder PA12 - , PBT (Polybutyletherphthalat, PMP (Polymethylpenten) und dergleichen enthält. Daneben können auch Kombinationen aus diesen Materialien eingesetzt werden. Die genannten Kunststoffe sind dabei z.T. Beispiele für strahlenvernetzbare Kunststoffe.

Grundsätzlich kommen als Materialien für das Verbindungsgehäuse die folgenden nicht abschließend aufgezählten Materialien in Frage:

| **Werkstoffgruppe** | **Modifikation** | **SHORE D** |
|---|---|---|
| **ABS** | | 75 - 93 |
| | ABS + 30 M.-% GF | 62-68 |
| | ABS / TPE | 46 |
| | ABS / TPU | 58-68 |
| **ASA** | | 75 |
| **ETFE** | | 60-78 |
| **EVA** | | 17-45 |
| **PA 11** | PA 11 + 23 M.-% GF | 70 |
| **PA 12** | PA 12 (normfeucht) | 75 - 78 |
| | PA 12 + 30 M.-% GF (normfeucht) | 75 |
| **PA 612** | | 73 |
| **PA 6** | PA 6 (normfeucht) | 52-77 |
| | PA 6 + 30 M.-% GF | 48 - 80 |
| | PA 6 + 30 M.-% GF (trocken) | 84 |
| **PA 66** | PA 66 + 30 M.-% GF | 77 - 82 |
| | PA 66 + 30 M.-% GB | 81 |
| | PA 66 + 30 M.-% MX | 75 - 82 |
| **PAEK** | | 86 - 90 |
| | PAEK + 30 M.-% GF | 90 |
| **PBI** | | 99 |
| **PBT** | | 79 - 86 |
| | PBT + 30 M.-% GF | 53 - 85 |
| | PBT + 30 M.-% GX | 54 |
| **PC** | | 51 - 85 |
| | PC + 30 M.-% GF | 65 - 72 |
| | PC + 30 M.-% GX | 70 |
| **PCTFE** | | 76 - 80 |
| **PE-HD** | | 56 - 69 |
| **PE-LD** | | 39 - 83 |
| **PE-LLD** | | 38-60 |
| **PE-MD** | | 45 - 60 |
| **PE-UHMW** | | 60 - 65 |
| **PEEK** | | 83 - 88 |
| **PEI** | | 88 - 90 |
| **PEK** | | 87 |
| | PEK + 30 M.-% GF | 90 |
| **PET** | PET + 30 M.-% GF | 63 - 65 |
| **PMMA** | | 52 - 85 |
| | PMMA + 30 M.-% GF | 55 |
| **POM** | | 52 - 83 |
| **PP** | | 59 - 77 |
| | PP + 30 M.-% GF | 62-80 |
| | PP + 30 M.-% CD | 74-75 |
| | PP + 30 M.-% MF | 60-74 |
| | PP + 30 M.-% P | 65 |
| | PP + 30 M.-% CaCO₃ | 55 - 70 |
| | PP / EPDM | 40 |
| **PS** | | 78 - 80 |
| **PTFE** | | 50 - 90 |
| **PUR** | | 20 - 84 |
| **PVC-U** | | 74 - 94 |
| | PVC-U / NBR | 58-74 |
| **PVC-P** | | 42 - 77 |
| **PVC-C** | | 82 |
| **PVDF** | | 46 - 79 |
| **SAN** | | 45 - 85 |
| **SMMA** | | 72 - 82 |
| **TPC** | | 28 - 82 |
| **TPE** | | 48 - 78 |
| | TPE / PTFE | 56 |
| **TPE-E** | TPE-E + 30 M.-% GF | 55 |
| **TPO** | | 16-70 |
| **TPS** | | 60 |
| **TPU** | TPU + 30 M.-% GF | 74-80 |
| **TPV** | | 40-51 |

wobei gilt:
GF: Glasfasern
GB: Glaskugeln
MF: Mineralfasern
MX: nicht spezifizierte Mineralfüllung
GX: nicht spezifizierte Glasfüllung
CD: Kohlenstoffmehl
P: nicht spezifiziertes Füllmehl

Zum Beispiel ist das Verbindungsgehäuse mit PC/ABS (einem Hartkunststoff) gebildet.

Denkbar ist, dass das Verbindungsgehäuse im montierten Zustand in Form eines Quaders mit einer jeweiligen Kantenlänge von wenigstens 20 bis höchstens 60mm gebildet ist. Es kann sich daher bei dem Verbindungsgehäuse, innerhalb welchem auch die Verbindungsbauelemente angeordnet sind, um eine sehr klein gebaute minimierte Einheit handeln.

Zum Beispiel weist die Leitungsschiene eine 24V-, sowie eine 48V-Leitung auf, wobei zu jeder der beiden Leitungen jeweils eine GND Leitung als Erdung angeordnet ist. Die Leitungsschiene kann in diesem Beispiel insgesamt vier Leitungen umfassen, die jeweils parallel zueinander verlaufen.

Denkbar ist, dass eine der beiden Leitungen (24V oder 48V) als eine Anschlussenergieversorgung für das Power-Plug Gehäuse und als ein an dieses dann angeschlossener Nutzungsgegenstand (zum Beispiel einem Roboter) dient.

Erfindungsgemäß weist das Verbindungsgehäuse an einer der Leitungsschiene zugewandten Seite Kontaktierungsschächte auf, welche in einer Richtung parallel zur Leitungsschiene, zumindest stellenweise, offen sind, wobei an einer Innenfläche jedes der Kontaktierungsschächte zumindest ein Schleifkontaktelement entlang verläuft, sodass innerhalb der Kontaktierungsschächte eine, jeweils einem Kontaktierungsschacht zugeordnete, elektrische Leitung der Leitungsschiene kontaktierbar ist.

Insofern können die Kontaktierungsschächte eine mechanische Führung für zum Beispiel die länglich ausgebildeten Schleifkontaktelemente sein. In jeweils einen Kontaktierungsschacht kann ein, vorzugsweise genau ein, Schleifkontaktelement, geführt und gelagert sein.

Erfindungsgemäß sind die Schleifkontaktelemente im Bereich der Kontaktierungsschächte wellenförmig ausgebildet sein. Alternativ oder zusätzlich jedoch dann nicht erfindungsgemäß können die Schleifkontakte in Form eines Hakens ausgebildet sein. Denkbar ist hierzu, dass ein als Haken ausgebildetes Ende eines Schleifkontakts noch vollständig in dem Kontaktierungsschacht gelagert ist und nicht aus diesem herausragt. Alternativ ist auch vorstellbar, dass das Hakenende zumindest teilweise aus dem Kontaktierungsschacht herausragt.

Zum Beispiel können neben den Schleifkontaktelementen die Kontaktierungsschächte in Form einer Aufsteckvorrichtung auf die einzelnen Leitungen ausgebildet sein.

Hierzu können die Kontaktierungsschächte selbst eine Steckverbindung in Form einer Clipsverbindung ausbilden. Eine solche Clipsverbindung kann ein Schnappelement (den Clips) umfassen, welcher sich nach dem Einrasten umfänglich um eine Leitung der Leitungsschiene legt. Das Schnappelement kann beweglich oder fest an dem Kontaktierungsschacht angeordnet sein, oder sogar ein Element des Kontaktierungsschachts selbst sein.

Gemäß zumindest einer Ausführungsform ist die mechanische Verbindung mit dem Verbindungsgehäuse, insbesondere nur, durch seitliches Aufschieben (= Aufklippen) des Schleifkontaktverbindung, insbesondere der Clipsverbindung der Schleifkontaktverbindung, auf jede der Leitung hergestellt.

Gemäß zumindest einer Ausführungsform verläuft zumindest ein Kontaktierungsschacht in einer zur Haupterstreckungsebene des Basisträgers senkrechter Richtung von dem Basisträger weg. Vorzugsweise verläuft die Leitungsschiene parallel oder in einer zu der Haupterstreckungsebene senkrechten Ebene des Basisträgers.

Gemäß zumindest einer Ausführungsform sind zumindest zwei Kontaktierungsschächte in einer zur Haupterstreckungsebene des Basisträgers parallelen Richtung übereinander angeordnet. Es kann sich bei dieser Anordnung daher um einen Kontaktierungsschachtstack handeln.

Ein Kontaktierungsschacht mündet daher in einem Hauptkörper des Verbindungsgehäuses. Er endet daher sobald er in den Hauptkörper mit seinen, vorzugsweise zu dem Kontaktierungsschacht senkrecht verlaufenden Seitenkanten übergeht.

Gemäß zumindest einer Ausführungsform ist zumindest ein Kontaktierungsschacht mit einem Kunststoff als ein Basismaterial gebildet, wobei in den Kunststoff vergossen und/oder auf eine Außenfläche des Kunststoffs zumindest stellenweise zumindest ein Verstärkungselement angeordnet ist, wobei das Verstärkungselement einen höheren Shore D-Wert aufweist als das Basismaterial.

Bei dem Verstärkungselement kann es sich um längliche Verstärkungsstreben handeln, welche zum Beispiel parallel zu einer Haupterstreckungsrichtung eines Kontaktierungsschachts in dem Kunststoff oder auf einer Oberfläche des Kunststoffs aufgebracht sind. Auch eine dazu senkrechte Verlegerichtung (zum Beispiel parallel zur Verfahrrichtung der Verbindungsvorrichtung) ist möglich. Die Verstärkungsstreben sind vorzugsweise mit einem härteren Material als das Basismaterial des Verbindungsgehäuses gefertigt. Insbesondere können die Verbindungsstreben einen höheren Shore D Wert aufweisen als das Basismaterial. Zum Beispiel sind die Verstärkungsstreben mit einem Metall, einem Kunststoff, und/oder einer Keramik gefertigt.

Gemäß zumindest einer Ausführungsform weist das Verbindungsgehäuse an einer der Leitungsschiene abgewandten Seite zumindest eine Verriegelung auf, mittels derer zumindest ein Power-Plug Gehäuse und/oder zumindest ein Connectormodul oder ein sonstiges mechanisches und/oder elektromechanisches Bauteil mechanisch fest, jedoch vorzugsweise lösbar, an der Verbindungsvorrichtung montierbar ist.

Denkbar ist, dass das Power-Plug Gehäuse als ein leitungsendseitiges Element ausgebildet ist, welches eine Abgreifschiene und deren elektrische Leiter an einem ihrer Enden mit dem Verbindungsgehäuse mechanisch fest, vorzugsweise jedoch lösbar verbindet. Dazu kann das Power-Plug Gehäuse auf einer Montagefläche des Basisträgers lösbar oder unlösbar mechanisch fixiert sein.

Die Verriegelung kann zumindest mit einem ihrer Enden mechanisch fest mit dem Basisträger oder zumindest mit dem Verbindungsgehäuse verbunden sein. In die Verriegelung kann ein Verbindungselement des Power-Plug Gehäuses eingebracht werden, sodass nach dem Verriegeln das Power-Plug Gehäuse mechanisch fest mit dem Verbindungsgehäuse verbunden ist.

Gemäß zumindest einer Ausführungsform ist die Verriegelung in Form eines Verriegelungshakens ausgebildet, wobei der Verriegelungshaken, zum Beispiel von außen umfänglich um das Power-Plug Gehäuse legbar ist, sodass, vorzugsweise nur, durch diese Verriegelung das Power-Plug Gehäuse an der Verbindungsvorrichtung gehalten wird.

Der Verriegelungshaken kann dabei mit einem Ende fest oder lösbar an den Basisträger oder dem Verbindungsgehäuses befestigt sein. Ein zweites Ende, des beispielsweise länglichen Verriegelungshakens, kann frei schwebend von dem Gehäuse wegstehen. Zwischen diesem freien Ende des Verriegelungshakens und dem restlichen Gehäuse kann dann das Power-Plug Gehäuse eingeführt werden. Nach der Einbringung des Power-Plug Gehäuses kann der Verriegelungshaken das Power-Plug Gehäuse, zum Beispiel zumindest teilweise, umfänglich an das Gehäuse der Verbindungsvorrichtung klammern.

Dabei kann nach dem Befestigen das Power-Plug Gehäuse elektrisch leitend mit den Schleifkontaktelementen verbunden sein. Hierzu kann der Basisträger entsprechende Durchkontaktierungen aufweisen. Die Abgreifvorrichtung kann das Power-Plug Gehäuse sein oder ein solches umfassen.

Gemäß zumindest einer Ausführungsform sind die Schleifkontaktelemente einstückig ausgebildet.

Im Folgenden wird die oben gezeigte Erfindung anhand von Ausführungsbeispielen und den dazugehörigen schematisch perspektivischen Ansichten näher erläutert.

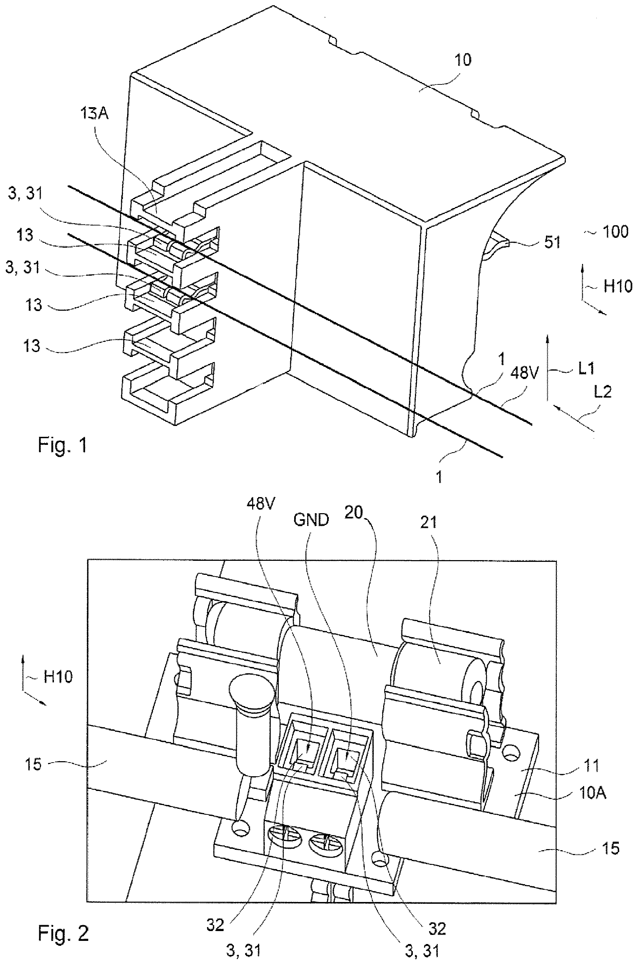

Dabei zeigen die Figuren 1, 2 und 4 ein erstes Ausführungsbeispiel in jeweils schematisch perspektivischen Ansichten einer hier beschriebenen Verbindungsvorrichtung 100.

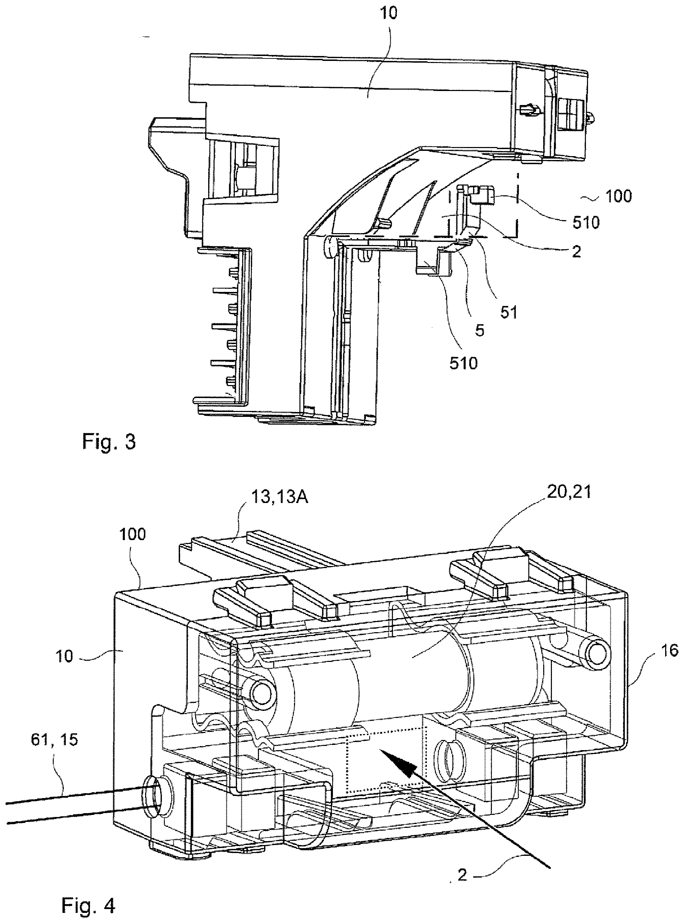

Die Figur 3 zeigt ein zweites Ausführungsbeispiel in einer schematisch perspektivischen Ansicht der hier beschriebenen Verbindungsvorrichtung 100.

In den Ausführungsbeispielen in den Figuren sind gleiche oder gleich wirkende Bestandteile jeweils mit den gleichen Bezugszeichen versehen. Die hier dargestellten Elemente sind nicht als maßstabsgerecht anzusehen, vielmehr können einzelne Elemente zum besseren Verständnis übertrieben groß dargestellt sein.

In der Figur 1 ist in einer schematisch perspektivischen Ansicht ein erstes Ausführungsbeispiel der hier beschriebenen Verbindungsvorrichtung 100 zur Übertragung elektrischer Energie von einer vorzugsweise räumlich fixierten Leitungsschiene 1 auf eine entlang der Leitungsschiene 1 bewegbare oder ebenso räumlich fixierte Abgreifvorrichtung 2 (in der Figur 1 aus Vereinfachungsgründen noch nicht dargestellt, siehe Figur 4) gezeigt.

Erkennbar ist aus der Figur 1, dass die Verbindungsvorrichtung 100 ein Verbindungsgehäuse 10 umfasst, wobei über das Verbindungsgehäuse 10 die Leitungsschiene 1 mechanisch mit der Abgreifvorrichtung 2 verbunden ist.

Dabei weist das Verbindungsgehäuse 10 eine Stromabgreifvorrichtung 3 auf, wobei die Stromabgreifvorrichtung 3 Schleifkontaktelemente 31 zur Abnahme elektrischer Energie von der Leitungsschiene 1 umfasst.

Von dem Verbindungsgehäuse 10 ragt ein Schachtsystem weg, welches durch in einer L1-Richtung übereinander gestapelten Kontaktierungsschächte 13 gebildet ist. In jedem der Kontaktierungsschächte 13 kann ein Schleifkontaktelement 31 positioniert und in L1-Richtung nach unten abgestützt sein.

Die Kontaktierungsschächte 13 sind in einer Verschieberichtung L2 beidseits offen, sodass jedes der Schleifkontaktelemente 31 problemlos jederzeit und kontinuierlich die ihm zugeordnete Leitung der Leitungsschiene 1 abgreifen kann. Insofern ist dargestellt, dass auf Innenflächen 13A von jedem Kontaktierungsschacht 13 ein Schleifkontaktelement 31 entlang verläuft und abgestützt ist.

Dabei verläuft jeder der Kontaktierungsschächte 13 in einer zur Haupterstreckungsebene H10, welche durch die Richtungen L1 und L2 aufgespannt ist, senkrechten Richtung von einem Basisträger 10A der Verbindungsvorrichtung 100 weg.

Der Basisträger 10A ist zum Beispiel in der Figur 2 gezeigt.

Wie ebenso aus der Figur 1 erkennbar ist, ist eine Leitung 48V der Leitungsschiene 1 eine +48 Volt elektrische Leitung und eine GND-Leitung insbesondere zur Erdung des Systems oder der elektrischen Verbindung.

Aus der Figur 2 ist erkennbar, dass eine Schutzbeschaltung 21 auf einer Montagefläche 11 des Basisträgers 10A erfindungsgemäß befestigt ist. Alternativ oder zusätzlich kann auch ein sonstiges Verbindungsbauelement 20 auf dieser Montagefläche 11 des Basisträgers 10A befestigt sein.

Ebenso dargestellt sind Kontaktierungsbereiche 32, welche vollständig durch den Basisträger 10A hindurch verlaufen. Mit anderen Worten sind die Kontaktierungsbereiche 32 auf einer Rückseite des Basisträgers 10A angeordnet, während die Kontaktierungsschächte 13 auf einer der Rückseite gegenüberliegenden Vorderseite des Basisträgers 10A angeordnet und ragen von dieser weg.

Erkennbar ist, dass innerhalb der Kontaktierungsbereiche 32 jedes der Schleifkontaktelemente 31 ebenso durch den Basisträger 10A hindurchgeführt ist.

In diese Kontaktierungsbereiche 32 kann dann die Abgreifvorrichtung 2 mit den elektrischen Kontakten beispielsweise eingesteckt oder elektrisch leitend verbunden werden. In diesem Fall kann daher die Abgreifvorrichtung 2 mit der Verbindungsvorrichtung 100 entlang der Leitungsschiene 1 mitbewegt werden.

Wie aus der Figur 2 erkennbar ist, bezeichnet das BZ 15 eine Mantelleitung, welche einen externen Verbraucher, z.B. einen Motor, mit elektrischer Energie versorgt. Der Motor kann ein Element des Fertigungselements sein.

Die Figur 3 zeigt eine Abgreifvorrichtung 2, insbesondere eine leere Abgreifvorrichtung (= Connectormodul), welche zur mechanischen Fixierung der Verbindungsvorrichtung 10 dienen kann.

Darüber hinaus weist die Abgreifvorrichtung 2 eine Verriegelung 5 in Form eines Verriegelungshakens 51 auf, sodass der Verriegelungshaken 51 die Verbindungsvorrichtung 10 umfänglich umklammern und einspannen kann. Durch die Abgreifvorrichtung 2 kann die hier beschriebene Verbindungsvorrichtung 10 an der Leitungsschiene befestigt werden.

Dabei ist zudem erkennbar, dass der Verriegelungshaken 51 zusätzliche Verriegelungselemente 510 aufweist. Diese zusätzlichen Verriegelungselemente 510 können ebenso in Form einer Steck-, das heißt Clipsverbindung ausgebildet sein.

Möglich ist auch, dass der Verriegelungshaken 51 anstatt umfänglich um die Verbindungsvorrichtung 10 gelegt zu werden, seitlich in ein Rastsystem der Verbindungsvorrichtung 10 eingetrieben wird. Ein derartiges Eintreiben kann eine Steckverbindung ausbilden. Der Verriegelungshaken 51 kann daher nach einem solchen Einstecken zumindest teilweise von der Abgreifvorrichtung 2 verdeckt sein.

In der Figur 4 ist die erfindungsgemäße Verbindungsvorrichtung 100 gemäß den Figuren 1 und 2 in einer vollständigen schematisch perspektivischen Ansicht gezeigt.

Erkennbar ist nämlich, dass wiederum die Schutzbeschaltung 21 sowie die Verbindungsschächte 13, als auch das Verbindungsgehäuse 10 vorhanden sind. Die Schutzbeschaltung 21 (vorzugsweise mit UL Zulassung) dient zur Absicherung der vorzugsweise 2-poligen Kontaktierungsbereiche 32.

Zudem ist der Figur 4 entnehmbar, dass in dieser eine strahlungsdurchlässige Deckklappe 16 das Verbindungsgehäuse 10 vervollständigt und somit ein Teil des Verbindungsgehäuses 10 sein kann. Es sind daher von der Deckklappe 16 sind alle weiteren Bauteile, welche eine elektrisch leitende Verbindung zwischen den Verbindungsschächten 13 und der Abgreifvorrichtung 2 bilden, eingeschlossen.

Die angedeutete elektrisch leitende Verbindung 61 kann ein elektrisch leitendes Kabel sein, welches in elektrisch leitender Verbindung mit den Kontaktierungsbereichen 32 steht und ist links- und rechtsseitig aus dem Verbindungsgehäuse 10 geführt. Zum Beispiel ist die elektrisch leitende Verbindung 61 ein Teil der Mantelleitung 15.

### Bezugszeichenliste

- 1: Leitungsschiene
- 2: Abgreifvorrichtung
- 3: Stromabgreifvorrichtung
- 5: Verriegelung
- 10: Verbindungsgehäuse
- 10A: Basisträger
- 11: Montagefläche
- 13: Kontaktierungsschächte
- 13A: Innenflächen
- 15: Mantelleitung
- 16: Deckklappe
- 20: Verbindungsbauelement
- 21: Schutzbeschaltung
- 31: Schleifkontaktelemente
- 32: Kontaktierungsbereiche
- 51: Verriegelungshaken
- 61: elektrisch leitende Verbindung
- 100: Verbindungsvorrichtung
- 510: Verriegelungselemente
- 48V: Leitung
- GND: GND-Leitung
- H10: Haupterstreckungsebene
- L1: Richtung
- L2: Verschieberichtung

## Patentansprüche

1. Verbindungsvorrichtung (100) zur Übertragung elektrischer Energie von einer räumlich fixierten Leitungsschiene (1) auf eine entlang der Leitungsschiene (1) bewegbare oder ebenso räumlich fixierte Abgreifvorrichtung (2), umfassend:
- zumindest ein Verbindungsgehäuse (10), wobei über das Verbindungsgehäuse (10) die Leitungsschiene (1) mechanisch mit der Abgreifvorrichtung (2) verbunden ist,
wobei das Verbindungsgehäuse (10) zumindest einen Basisträger (10A) umfasst, auf welchem an einer Montagefläche (11) Verbindungsbauelemente (20) montiert sind,
- eine Stromabgreifvorrichtung (3), welche Schleifkontaktelemente (31) zur Abnahme elektrischer Energie von der Leitungsschiene (1) umfasst, wobei die Schleifkontaktelemente (31) durch den Basisträger (10A) hindurch geführt sind und auf einer der Leitungsschiene (1) abgewandten Seite des Basisträgers (10A) einen Kontaktierungsbereich (32) aufweisen, mittels dessen zumindest eine Leiterplatine der Verbindungsvorrichtung (100) und/oder zumindest eine Leiterplatine der Abgreifvorrichtung (2) und/oder zumindest eine Motorleiterplatine elektrisch leitend kontaktiert ist,
wobei
das Verbindungsgehäuse (10) an einer der Leitungsschiene (1) zugewandten Seite Kontaktierungsschächte (13) aufweist, welche in einer Richtung parallel zur Leitungsschiene (1) zumindest stellenweise offen sind, wobei an einer Innenfläche (13A) jedes der Kontaktierungsschächte (13) zumindest ein Schleifkontaktelement (31) entlang verläuft, sodass innerhalb der Kontaktierungsschächte (13) eine jeweils einem Kontaktierungsschacht (13) zugeordnete elektrische Leitung der Leitungsschiene (1) kontaktierbar ist, und weiter wobei
die Schleifkontaktelemente (31) im Bereich der Kontaktierungsschächte (13) wellenförmig ausgebildet sind, und weiter wobei
die Kontaktierungsschächte (13) in Form einer Aufsteckvorrichtung auf die einzelnen Leitungen ausgebildet sind,
**dadurch gekennzeichnet, dass**
die Verbindungsbauelemente (20) zumindest eine Anschlussklemme und eine Schutzbeschaltung (21) umfassen, und dass
die Schutzbeschaltung (21) auf der Montagefläche (11) des Basisträgers (10A) befestigt ist.

2. Verbindungsvorrichtung (100) nach Anspruch 1,
**dadurch gekennzeichnet, dass**
die Schleifkontaktelemente (31) in Form von Schleifaufsteckelementen ausgebildet sind, sodass das Verbindungsgehäuse (10) werkzeugfrei auf die Leitungsschiene aufsteckbar ist, und wobei ein Schleifaufsteckelement ein Element ist, welches an eine Leitung der Leitungsschiene aus einer Richtung anordenbar ist und während des Anpositioniervorgangs eine Steckverbindung zwischen der Leitungsschiene und dem Verbindungsgehäuse entsteht.

3. Verbindungsvorrichtung (100) nach Anspruch 1 oder 2,
**dadurch gekennzeichnet, dass**
zumindest ein Kontaktierungsschacht (13) in einer zur Haupterstreckungsebene (H10) des Basisträgers (10A) senkrechten Richtung von dem Basisträger (10A) wegverläuft.

4. Verbindungsvorrichtung (100) nach einem der vorhergehenden Ansprüche,
**dadurch gekennzeichnet, dass**
zumindest ein Kontaktierungsschacht mit einem Kunststoff als ein Basismaterial gebildet ist, wobei in den Kunststoff vergossen und/oder auf einer Außenfläche des Kunststoffs zumindest stellenweise zumindest ein Verstärkungselement angeordnet ist, wobei das Verstärkungselement einen höheren Shore D-Wert aufweist als das Basismaterial.

5. Verbindungsvorrichtung (100) nach einem der vorhergehenden Ansprüche,
**dadurch gekennzeichnet, dass**
zumindest zwei Kontaktierungsschächte (13) in einer zur Haupterstreckungsebene (H10) des Basisträgers (10A) senkrechten Richtung übereinander angeordnet sind.

6. Verbindungsvorrichtung (100) nach einem der vorhergehenden Ansprüche,
**dadurch gekennzeichnet, dass**
das Verbindungsgehäuse (10) an einer der Leitungsschiene (1) abgewandten Seite zumindest eine Verriegelung (5) aufweist, mittels der zumindest ein Power-Plug Gehäuse (6) mechanisch fest, jedoch lösbar an der Verbindungsvorrichtung (10) montierbar ist.

7. Verbindungsvorrichtung (100) nach Anspruch 6,
**dadurch gekennzeichnet, dass**
die Verriegelung (5) in Form eines Verriegelungshakens (51) ausgebildet ist, wobei der Verriegelungshaken (51) von außen umfänglich um das Power-Plug Gehäuse (6) legbar ist, sodass durch diese Verriegelung das Power-Plug Gehäuse (6) an der Verbindungsvorrichtung (100) gehalten wird.

8. Verbindungsvorrichtung (100) nach n Anspruch 6 oder 7,
**dadurch gekennzeichnet, dass**
nur durch diese Verriegelung (5) das Power-Plug Gehäuse (6) an der Verbindungsvorrichtung (100) gehalten wird.

9. Verbindungsvorrichtung (100) nach einem der vorhergehenden Ansprüche,
**dadurch gekennzeichnet, dass**
die Schleifkontaktelemente (31) einstückig ausgebildet sind.

## Claims

1. Connecting device (100) for transmitting electrical energy from a spatially fixed conductor rail (1) to a tapping device (2) which can be moved along the conductor rail (1) or is also spatially fixed, comprising:
- at least one connection housing (10), wherein the line rail (1) is mechanically connected to the pick-off device (2) via the connection housing (10),
the connection housing (10) comprising at least one base support (10A) on which connection components (20) are mounted on a mounting surface (11),
- a current pick-up device (3) which comprises sliding contact elements (31) for picking up electrical energy from the conductor rail (1), the sliding contact elements (31) being guided through the base support (10A) and having, on a side of the base support (10A) facing away from the conductor rail (1), a contacting region (32) by means of which at least one printed circuit board of the connection device (100) and/or at least one printed circuit board of the pick-up device (2) and/or at least one motor printed circuit board is electrically conductively contacted,
wherein
the connection housing (10) has contacting shafts (13) on a side facing the conductor rail (1), which contacting shafts (13) are open at least in places in a direction parallel to the conductor rail (1), at least one sliding contact element (31) running along an inner surface (13A) of each of the contacting shafts (13), so that an electrical line of the conductor rail (1), which is in each case assigned to a contacting shaft (13), can be contacted within the contacting shafts (13), and further wherein
the sliding contact elements (31) in the region of the contacting shafts (13) are of wave-shaped design, and further wherein
the contacting shafts (13) are designed in the form of a plug-on device on the individual lines,
**characterised in that**
the connection components (20) comprise at least one terminal and a protective circuit (21), and **in that**
the protective circuit (21) is fixed on the mounting surface (11) of the base support (10A).

2. Connecting device (100) according to claim 1,
**characterised in that**
the sliding contact elements (31) are designed in the form of sliding plug-in elements, so that the connection housing (10) can be plugged onto the conductor rail without tools, and wherein a sliding plug-in element is an element which can be arranged on a line of the conductor rail from one direction and a plug-in connection is produced between the conductor rail and the connection housing during the positioning operation.

3. Connection device (100) according to claim 1 or 2,
**characterized in that**
at least one contacting shaft (13) extends away from the base support (10A) in a direction perpendicular to the main extension plane (H10) of the base support (10A).

4. Connection device (100) according to any one of the preceding claims,
**characterized in that**
at least one contacting shaft is formed with a plastic as a base material, wherein at least one reinforcing element is moulded into the plastic and/or is arranged on an outer surface of the plastic at least in places, wherein the reinforcing element has a higher Shore D value than the base material.

5. Connection device (100) according to any one of the preceding claims,
**characterized in that**
at least two contacting shafts (13) are arranged one above the other in a direction perpendicular to the main extension plane (H10) of the base support (10A).

6. Connection device (100) according to any one of the preceding claims,
**characterised in that**
the connection housing (10) has, on a side facing away from the conductor rail (1), at least one latch (5) by means of which at least one power plug housing (6) can be mounted mechanically fixedly but releasably on the connection device (10).

7. Connection device (100) according to claim 6,
**characterized in that**
the locking device (5) is in the form of a locking hook (51), wherein the locking hook (51) can be placed circumferentially around the power plug housing (6) from the outside, so that the power plug housing (6) is held on the connecting device (100) by this locking device.

8. Connection device (100) according to claim 6 or 7,
**characterised in that**
the power plug housing (6) is held on the connection device (100) only by this latch (5).

9. Connection device (100) according to one of the preceding claims,
**characterized in that**
the sliding contact elements (31) are formed in one piece.

## Revendications

1. Dispositif de connexion (100) pour la transmission d'énergie électrique d'un rail conducteur (1) fixe dans l'espace à un dispositif de prélèvement (2) mobile le long du rail conducteur (1) ou également fixe dans l'espace, comprenant:
- au moins un boîtier de liaison (10), le rail conducteur (1) étant relié mécaniquement au dispositif de prélèvement (2) par l'intermédiaire du boîtier de liaison (10),
le boîtier de connexion (10) comprenant au moins un support de base (10A) sur lequel des composants de connexion (20) sont montés sur une surface de montage (11),
- un dispositif de prélèvement de courant (3) qui comprend des éléments de contact glissant (31) pour prélever de l'énergie électrique du rail conducteur (1), les éléments de contact glissant (31) étant guidés à travers le support de base (10A) et présentant, sur un côté du support de base (10A) opposé au rail conducteur (1), une zone de contact (32) au moyen de laquelle au moins une platine conductrice du dispositif de connexion (100) et/ou au moins une platine conductrice du dispositif de prélèvement (2) et/ou au moins une platine conductrice de moteur est en contact électriquement conducteur,
où
le boîtier de connexion (10) présente, sur un côté tourné vers le rail conducteur (1), des puits de contact (13) qui sont ouverts au moins par endroits dans une direction parallèle au rail conducteur (1), au moins un élément de contact glissant (31) s'étendant le long d'une surface intérieure (13A) de chacun des puits de contact (13), de sorte qu'une ligne électrique du rail conducteur (1) associée respectivement à un puits de contact (13) peut être contactée à l'intérieur des puits de contact (13), et en outre dans lequel
les éléments de contact glissants (31) sont ondulés dans la zone des puits de contact (13), et en outre dans lequel
les puits de contact (13) sont réalisés sous la forme d'un dispositif d'enfichage sur les différents conducteurs,
**caractérisé en ce que**
les composants de connexion (20) comprennent au moins une borne de connexion et un circuit de protection (21), et **en ce que**
le circuit de protection (21) est fixé sur la surface de montage (11) du support de base (10A).

2. Dispositif de connexion (100) selon la revendication 1,
**caractérisé en ce que**
les éléments de contact glissant (31) sont réalisés sous la forme d'éléments d'emboîtement glissant, de sorte que le boîtier de connexion (10) peut être emboîté sans outil sur le rail conducteur, et dans lequel un élément d'emboîtement glissant est un élément qui peut être disposé sur une ligne du rail conducteur à partir d'une direction et, pendant le processus de positionnement, une connexion par emboîtement est créée entre le rail conducteur et le boîtier de connexion.

3. Dispositif de connexion (100) selon la revendication 1 ou 2,
**caractérisé en ce que**
au moins un puits de contact (13) s'éloigne du support de base (10A) dans une direction perpendiculaire au plan d'extension principal (H10) du support de base (10A).

4. Dispositif de connexion (100) selon l'une quelconque des revendications précédentes, **caractérisé en ce que**
au moins un puits de contact est formé avec une matière plastique comme matériau de base, au moins un élément de renforcement étant coulé dans la matière plastique et/ou disposé au moins par endroits sur une surface extérieure de la matière plastique, l'élément de renforcement présentant une valeur Shore D plus élevée que le matériau de base.

5. Dispositif de connexion (100) selon l'une quelconque des revendications précédentes, **caractérisé en ce que**
au moins deux puits de contact (13) sont superposés dans une direction perpendiculaire au plan d'extension principal (H10) du support de base (10A).

6. Dispositif de connexion (100) selon l'une quelconque des revendications précédentes, **caractérisé en ce que**
le boîtier de connexion (10) présente, sur un côté opposé à la barre conductrice (1), au moins un verrouillage (5) au moyen duquel au moins un boîtier Power-Plug (6) peut être monté mécaniquement de manière fixe, mais amovible, sur le dispositif de connexion (10).

7. Dispositif de connexion (100) selon la revendication 6,
**caractérisé en ce que**
le verrouillage (5) est réalisé sous la forme d'un crochet de verrouillage (51), le crochet de verrouillage (51) pouvant être placé de l'extérieur sur la circonférence du boîtier Power-Plug (6), de sorte que le boîtier Power-Plug (6) est maintenu sur le dispositif de connexion (100) par ce verrouillage.

8. Dispositif de connexion (100) selon la revendication 6 ou 7,
**caractérisé en ce que**
seul ce verrouillage (5) permet de maintenir le boîtier Power-Plug (6) sur le dispositif de connexion (100).

9. Dispositif de connexion (100) selon l'une quelconque des revendications précédentes, **caractérisé en ce que**
les éléments de contact glissants (31) sont formés d'une seule pièce.
